# EUROPÄISCHE PATENTSCHRIFT

(11) **EP 4 389 394 B1**
(45) Veröffentlichungstag und Bekanntmachung des Hinweises auf die Patenterteilung: **28.10.2026**
(21) Anmeldenummer: 23217675.0
(22) Anmeldetag: 18.12.2023
(51) Int. Cl.: B29C 63/00, B32B 38/10, H05K 3/28, H10P 72/00

(54) **VORRICHTUNG UND VERFAHREN ZUM ABZIEHEN VON SCHUTZFOLIEN VON PLATTENFÖRMIGEN GEGENSTÄNDEN**
DEVICE AND METHOD FOR REMOVING PROTECTIVE FILMS FROM PLATE-SHAPED OBJECTS
DISPOSITIF ET PROCÉDÉ POUR ENLEVER DES FEUILLES PROTECTRICES D'OBJETS EN FORME DE PLAQUES

(30) Priorität: 22.12.2022 DE 102022134515
(43) Veröffentlichungstag der Anmeldung: 26.06.2024
(73) Patentinhaber: Advanced Engineering Industrie Automation GmbH, 5400 Hallein, Salzburg (AT)
(72) Erfinder: Moser, Lukas, 5524 Annaberg (AT); Moser, Tim, 5524 Annaberg (AT)
(74) Vertreter: Riebling, Peter

(56) Entgegenhaltungen:
- WO-A1-2017/038468
- DE-B4- 10 296 951
- KR-A- 20040 083 579

## Beschreibung

Die Erfindung betrifft eine Vorrichtung und Verfahren zum Abziehen von Schutzfolien von plattenförmigen Gegenständen nach dem Oberbegriff des Patentanspruches 1 und des Patentanspruches 13.

Eine derartige Schutzfolie wird beispielsweise bei der Herstellung von Leiterplatten oder von Glas- oder Keramikflächen eingesetzt. Die Schutzfolien sind als selbstklebende oder ohne Kleber als statisch haftende Folie ausgebildet. Bei der Glasherstellung dient eine solche Folie als Schutz vor Verkratzen oder Verschmutzung während der Bearbeitung, der Lagerung und dem Transport.

Bei der Herstellung einer Leiterplatte ist es bereits bekannt auf kupferkaschierte Leitersubstratplatten Fotopolymerschichten mit Schutzfolien mittels so genannter Cut-Sheet-Laminatoren vollautomatisch u. a. beidseitig aufzulaminieren. Hierbei werden beschnittene Fotopolymerschichten mit einer vom Rand beabstandeten Schutzfolie auf kupferkaschierten Leiterplattensubstraten appliziert. Bevorzugt weist die Folie einen Randabstand, zwischen 0,5 mm bis 15 mm auf. Die Schutzfolie muss jedoch im Laufe des Bearbeitungsprozesses wieder von der Leiterplatte entfernt werden.

Bisher haben vollautomatische Anlagen sowohl die Fotopolymerschicht mit der Schutzfolie auflaminiert, als auch die Schutzfolie wieder entfernen können. Beim Entfernen der Folie wurde jedoch kein gutes Ergebnis erzielt. Speziell das Abziehen bzw. das Peelen der Schutzfolie von der Fotopolymerschicht nach dem Belichtungsvorgang stellt ein Problem dar.

Mit der DE 10 2014 011 721 A1 wird ein Vorrichtung und Verfahren zum Abziehen von Schutzfolien offenbart, wobei eine Leiterplatte mit den aufgebrachten Schutzfolien in den Walzenspalt einer Peeleinheit zugeführt wird und keilförmige Schwerter zwischen die Leiterplatte und die Schutzfolien eingreifen und die Schutzfolien von der Leiterplatte ablösen. Die abgelösten Schutzfolien werden von einer drehend angetriebenen Trommel mitgenommen, wobei vor den Schwertern Luftdüsen vorhanden sind, welche einen Luftstrom erzeugen und den abgelösten Teil der Schutzfolie an den Außenumfang der Trommel anlegen.

Da der Abziehvorgang in einem Reinraum stattfindet, wirkt sich der erzeugte Luftstrom nachteilig aus, da es dadurch zu unerwünschten Verwirbelungen kommt. Des Weiteren besteht das Problem, dass die PET-Supportfolien eine sehr hohe Haftung auf dem ABF aufweisen und speziell an den Rändern durch die hohe Steifigkeit und hohe Temperaturstabilität der PET-Supportfolien nahezu in die ABF eingeschmolzen sind und daher nur schwer mit einem Luftstrom losgelöst werden können.

Für die Herstellung von Prozessoren und Grafikchips sind eine Vielzahl an Komponenten notwendig. Eine wichtige davon ist der Ajinomoto Build-up-Film (ABF), welche als isolierende Folie für Träger genutzt wird, um die Chips auf die eigentliche Platine zu setzen. Der Träger führt die Kontakte des Dies ins Freie, sodass diese angesprochen werden können. Die isolierende Folie, insbesondere der Ajinomoto Build-up-Film muss hohe Anforderungen, wie z.B. eine gleichmäßige Isolationsschicht, hohe Hitzebeständigkeit auch bei starken Temperaturschwankungen, sowie eine hohe mechanische Stabilität aufweisen.

Aus dem Stand der Technik sind bereits Vorrichtungen und Verfahren zum Abziehen eines derartigen Ajinomoto Build-up-Films (ABF) bekannt, welcher nach dem Vakuum-Laminierprozess auf Leiterplatten-Innenlagen und der Abkühlung auf Raumtemperatur abgezogen werden muss.

Mit der KR 1020150049100 A wird ein Abziehverfahren für eine Schutzfolie offenbart, wobei die Schutzfolie zunächst mit einem Folienablöser, welcher als Rändelrolle ausgebildet ist, bearbeitet wird und danach in dem vordere Endabschnitt mit einem Abziehband verbunden und von dem plattenförmigen Gegenstand abgezogen wird.

Die EP 1 128 415 B2 offenbart eine Folienentfernungsvorrichtung, welche mit Hilfe eines Klebebands eine Folie von einem plattenförmigen Element entfernt, wobei das Klebeband durch einen Heißpressvorgang mit einem Verbindungsvorrichtung mit dem Randabschnitt verbunden und im Anschluss daran mit einer Zugvorrichtung schräg nach oben abgezogen wird.

Mit der DE 102 96 951 B4 wird ein Verfahren zum Entfernen eines Deckschichtrandes von Fenstergläsern, wobei ein Klebeband auf den Randbereich der Deckschicht aufgeklebt wird. Im Anschluss daran wird der Randbereich der Deckschicht mittels des Klebebands von der Platte abgehoben und der Randbereich von der übrigen Deckschicht abgeschnitten.

Mit der WO 2017/038468 A1 wird eine Vorrichtung zum Ablösen einer Klebefolie von der Oberfläche eines Wafers offenbart. Hierfür wird ein Abziehband mit einem Klebemittel auf die Klebefolie aufgeklebt. Mit Hilfe einer Zugvorrichtung wird eine Spannung auf das Abziehband aufgebracht und dadurch die Klebefolie von einer Klebefläche abgelöst. Die Vorrichtung weist zusätzlich ein Faltmittel zum Falten der abgelösten Klebefolie auf, wobei mit einem Führungsmittel die Klebefolie (AS) in der Hälfte gefaltet wird.

Die KR 2004 0083579 A offenbart eine Vorrichtung zum automatisierten Abziehen einer Schutzfolie von einer Leiterplatte. Die Vorrichtung weist hierfür mehrere Übertragungswalzen auf, mit welchen die Leiterplatte innerhalb der Abziehvorrichtung bewegbar ist. An einem Ende der Übertragungswalzen befindet sich eine Klebebandvorrichtung, welche vertikal beweglich ist und jeweils ein Klebeband auf die Ober- und Unterseite der Leiterplatte aufklebt. Bei einem Abheben der Klebebandvorrichtung von der Leiterplatte werden durch die Klebewirkung die beiden Schutzfolien von der Leiterplatte abgelöst. Im Bereich der Klebebandvorrichtung befinden sich ferner Vakuumdüsen, welche die abgelösten Schutzfolien ansaugen. Die Schutzfolien werden danach von zwei Vakuumtrommeln aufgenommen und zu einem Sammelbehälter befördert.

Die bekannten Abziehverfahren funktionieren nur teilweise gut und lassen sich nur bedingt automatisieren.

Der Erfindung liegt deshalb die Aufgabe zugrunde, eine Vorrichtung und ein Verfahren zum Abziehen einer Schutzfolien dergestalt weiterzubilden, dass der automatisierte Abziehvorgang verbessert wird.

Zur Lösung der gestellten Aufgabe ist die Erfindung durch die technische Lehre des Anspruches 1 und des Anspruches 13 gekennzeichnet.

Wesentliches Merkmal der Erfindung ist, dass zur Applizierung des Klebebands die Vorrichtung mindestens einen schwenkbaren Kontaktarm und einem daran angeordneten Stempel mit einer Stempelfläche aufweist.

Unter dem Begriff Applizierung werden alle Vorgänge verstanden, welche notwendig sind, um das Klebeband mit der Schutzfolie zu kontaktieren und die Schutzfolie mit Hilfe des Klebebands zumindest teilweise von dem plattenförmigen Gegenstand an- bzw. abzuheben.

Bei einer ersten bevorzugten Ausführungsform weist die Vorrichtung zum Ablösen der Schutzfolie mindestens einen schwenkbaren Kontaktarm und einem daran schwenkbar angeordneten Stempel auf. Der Stempel dient zum flächigen Kontaktieren eines Klebebands mit der Schutzfolie und unterstützt das leichtere Ablösen der Schutzfolien von dem plattenförmigen Gegenstand. Mit Hilfe eines Antriebs lässt sich der Kontaktarm zusammen mit dem Stempel mit einem definierten Druck auf die Oberfläche des plattenförmigen Gegenstands mit der Schutzfolie aufsetzen und wieder von dieser wegbewegen.

Unter einem Klebeband wird ein streifenförmiges Trägermaterial verstanden, welches ein- oder beidseitig mit Haftklebstoff beschichtet ist. Das Klebeband ist hinsichtlich der Haftung, der Kohäsion und der Klebrigkeit an die jeweilige Schutzfolie angepasst.

Das Klebeband befindet sich in einem ersten Klebebandspender und kann gesteuert abgegeben werden. Der Klebebandspender ist beispielsweise als Rolle oder Klebebandabroller ausgebildet. Unter einer gezielten, gesteuerten Abgabe wird verstanden, dass das Klebeband entweder auf Zugspannung gehalten oder mit einer bestimmten Geschwindigkeit abgegeben wird. Die gewünschte Abgabe erfolgt gesteuert und in Abstimmung mit dem schwenkbaren Stempel.

Vorzugsweise befindet sich das Klebeband auf einem ersten Klebebandspender und wird über den Stempel zu einem Klebebandsammler geführt. Sowohl der Klebebandspender, als auch der Klebebandsammler können als Rollen ausgeführt sein, so dass das Klebeband von der ersten Rolle ab- und von der zweiten Rolle wieder aufgerollt wird.

Der Kontaktarm weist vorzugsweise einen Kontaktkopf auf, welcher zunächst in Richtung des plattenförmigen Gegenstands abgesenkt und mit einem gewissen Abstand gegenüber dem plattenförmigen Gegenstand gehalten wird. Im Anschluss daran wird der Stempel aus dem Kontaktkopf ausgeschwenkt, wobei durch das Ausschwenken des Stempels eine Zugkraft auf das Klebeband erzeugt wird, so dass weiteres Klebeband von dem ersten Klebebandspender abgegeben wird. Optimalerweise ist die Stempelfläche des Stempels vollflächig mit dem Klebeband bedeckt. Der Stempel wird vorzugsweise soweit ausgeschwenkt, dass die Stempelfläche parallel zu der Oberfläche des plattenförmigen Gegenstands ist. Danach wird der Kontaktarm weiter abgesenkt, bis die Stempelfläche mit dem Klebeband vollflächig auf der Schutzfolie aufliegt. Das Klebeband haftet nun an der Schutzfolie an.

Danach wird der Stempel wieder eingeschwenkt, wobei das Klebeband weiterhin auf der Schutzfolie anhaftet. Durch ein erstes Anheben des Kontaktarms mit einem definierten Abstand wird die Schutzfolie von dem plattenförmigen Gegenstand gelöst. Im Anschluss daran wird das Klebeband von dem Klebebandsammler aufgerollt, wobei das Klebeband nach oben über eine hierfür vorgesehene Rolle am Kontaktkopf zum Klebebandsammler abgeführt wird. Durch das nach oben Abführen des Klebebands findet ein definiertes Lösen der Schutzfolie von dem plattenförmigen Gegenstand statt. Vorzugsweise blockiert gleichzeitig der Klebebandspender eine weitere Abgabe bzw. ein Nachführen des Klebebandes, so dass mit einer Zugspannung sich das Klebeband wieder flächig an die Stempelfläche des hochgeschwenkten Stempels anlegt. Der Kontaktarm befindet sich weiterhin mit einem definierten Abstand über dem plattenförmigen Gegenstand. Die Schutzfolie ist zumindest im Randbereich von dem plattenförmigen Gegenstand abgezogen.

Bei einer bevorzugten Ausführungsform weist die Vorrichtung zum Ablösen der Schutzfolie eine Klemmvorrichtung mit mindestens einem Greifer zum Greifen und Klemmen der abgelösten Schutzfolie auf. Vorzugsweise befinden sich zwei beabstandete, gegenüberliegende Greifer in einer definierten Höhe, jeweils im Randbereich des plattenförmigen Gegenstands, so dass die abgelöste Schutzfolie beidseitige von den Greifern geklemmt wird.

Die Klemmvorrichtung ist im Bereich zumindest einer (Abzieh-)Trommel angeordnet, welche die abgelöste Schutzfolie von den Greifern aufnimmt und von dem plattenförmigen Gegenstand weiter abzieht. Die Trommel nimmt über die Greifer der Klemmvorrichtung die Schutzfolie auf. Es ist ferner möglich, dass ein Vakuumsauger im Bereich der Trommel ein Vakuum erzeugt und die abgelöste Schutzfolie an der Oberfläche der Trommel hält.

Bei einer bevorzugten Ausführungsform weist die Klemmvorrichtung zwei beabstandet Greifer auf, welche sich auf beiden Seiten der Trommel befinden. Die Greifer dienen zum Greifen und Halten der abgelösten Schutzfolie und geben die abgelöste Schutzfolie an die Trommel ab. Die Greifer werden von einem Antrieb gesteuert, welcher sich außerhalb der Trommel befindet. Der Antrieb für die Greifer ist beispielsweise als (Arbeits-)Zylinder ausgebildet, welcher seine lineare Kraft an eine Kulissenführung abgibt und dadurch eine Rotationsbewegung erzeugt. Die Rotationsbewegung wird an eine Welle abgegeben, welche sich durch die Trommel erstreckt. Der Greifer weist eine Kniehebelvorrichtung auf, wobei bei einer Rotationsbewegung der Welle, der Greifer geöffnet bzw. geschlossen wird. Die vorliegende Ausführungsform mit einer drehenden Welle durch die Trommel hat den wesentlichen Vorteil, dass keine beweglichen Bauteile in bzw. im Bereich der Trommel angeordnet werden müssen. Die Rotationsbewegung der Welle kann beabstandet von der Trommel erzeugt werden, so dass im Bereich der Trommel keine Antriebseinheiten für die Bewegung der Greifer notwendig sind.

Mit der vorliegenden Patentanmeldung wird nicht nur ein Schutz für eine Vorrichtung zum Ablösen der Schutzfolie mit einem Kontaktarm und einem schwenkbaren Stempel beansprucht, sondern auch eine Kombination mit dem Kontaktarm und einer Ablösevorrichtung, mit welcher zuvor die Schutzfolie im Randbereich des plattenförmigen Gegenstands gelöst wird.

Bei einer bevorzugten Ausführungsform weist die Vorrichtung zum Ablösen der Schutzfolie eine Ablösevorrichtung auf, mit welcher der Rand der Schutzfolie mechanisch von dem plattenförmigen Gegenstand gelockert wird. Die Ablösevorrichtung ist vorzugsweise als Rändel- oder Walzvorrichtung ausgebildet, wobei eine Rolle gegen den Rand des plattenförmigen Gegenstands gepresst und abgewälzt wird und dabei eine Druckkraft auf den plattenförmigen Gegenstand übertragen wird. Es findet somit eine Druckumformung im Randbereich des plattenförmigen Gegenstands statt, wodurch die Schutzfolie "gestresst" wird und sich dadurch im Randbereich ablöst. Ein solches Lösen der Folie ist vorteilhaft, um im Anschluss daran die Schutzfolie mit dem Kontaktarm und dem daran schwenkbar angeordneten Stempel mit dem Klebeband aufzunehmen.

Die Ablösevorrichtung weist vorzugsweise mindestens eine schräg angestellte, glatte Rolle auf. Die Anstellung der Rolle erfolgt beispielsweise in einem Winkel von ca. 5-30° zur Verfahrensachse. Durch die Anordnung der Rolle in einem Winkel zur Vorschubbewegung und durch eine definierte Druckkraft auf die Rolle wird bei einer Bewegung der Rolle auf dem plattenförmigen Gegenstand entlang des Randbereichs die Schutzfolie in diesem Bereich gelöst.

Bei einer weiteren bevorzugten Ausführungsform hält mindestes eine Haltevorrichtung den plattenförmigen Gegenstand während des Ablösevorgangs.

Neben der oben genannten Vorrichtung zum Ablösen der Schutzfolie wird mit der vorliegenden Patentanmeldung auch ein Schutz für ein Verfahren zum Ablösen einer Schutzfolie von einem plattenförmigen Gegenstand beansprucht.

Bei einer bevorzugten Ausführungsform weist das Verfahren zum Ablösen einer Schutzfolie von einem plattenförmigen Gegenstand folgende Verfahrensschritte auf:
- Absenken eines Kontaktarms mit einem Kontaktkopf und einem daran schwenkbar angeordneten Stempel in Richtung des plattenförmigen Gegenstands;
- Ausschwenken des Stempels aus dem Kontaktkopf bis die Stempelfläche parallel zur Oberfläche des plattenförmigen Gegenstands ist, wobei beim Ausschwenken des Stempels sich das Klebeband an die Stempelfläche anlegt;
- Aufsetzen des Stempels auf die Schutzfolie des plattenförmigen Gegenstands und damit flächiges Kontaktieren des Klebebands mit der Schutzfolie;
- Einschwenken des Stempels in den Kontaktkopf;
- Anheben des Kontaktarms mit einem definierten Abstand gegenüber dem plattenförmigen Gegenstand, wobei gleichzeitig die Schutzfolie von dem plattenförmigen Gegenstand angehoben wird;
- Einziehen des Klebebands über eine Rolle am Kontaktkopf durch eine Klebebandsammler;
- Greifen der abgelösten Schutzfolie mit mindestens einem Greifer einer Klemmvorrichtung;
- Übergabe der gelösten Schutzfolie ausgehend von der Klemmvorrichtung auf eine Trommel, welche die weitere Schutzfolie von dem plattenförmigen Gegenstand abzieht.

Bei einer weiteren bevorzugten Ausführungsform ist der Klebebandspender und der Klebebandsammler gesteuert. So kann beispielsweise während dem Ablösen der Schutzfolie von dem plattenförmigen Gegenstand der Klebebandspender gesperrt sein, so dass kein weiteres Klebeband nachgeführt wird, während der Klebebandsammler das bereits benutzte Klebeband einzieht.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Im Folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: schematische Darstellung der Ablösevorrichtung;
- Figur 2:: perspektivische Darstellung der erfindungsgemäßen Vorrichtung mit einem plattenförmigen Gegenstand;
- Figur 3:: schematische Seitenansicht der erfindungsgemäßen Vorrichtung mit abgesenktem Kontaktarm;
- Figur 4:: schematische Seitenansicht der erfindungsgemäßen Vorrichtung mit abgesenktem Kontaktarm und geschwenkter Stempelfläche;
- Figur 5:: schematische Seitenansicht der erfindungsgemäßen Vorrichtung mit angehobenen Kontaktarm und gelöster Schutzfolie;
- Figur 6:: schematische Seitenansicht der erfindungsgemäßen Vorrichtung mit angehobenen Kontaktarm und geschwenkten Greifer der Klemmvorrichtung;
- Figur 7:: schematische Seitenansicht der erfindungsgemäßen Vorrichtung mit angehobenen Kontaktarm und geklemmter Schutzfolie;
- Figur 8:: schematische Seitenansicht der erfindungsgemäßen Vorrichtung mit aufgenommener Schutzfolie von der Trommel;
- Figur 9:: schematische Darstellung der Welle von der Klemmvorrichtung;
- Figur 10:: schematische Darstellung der Klemmvorrichtung;

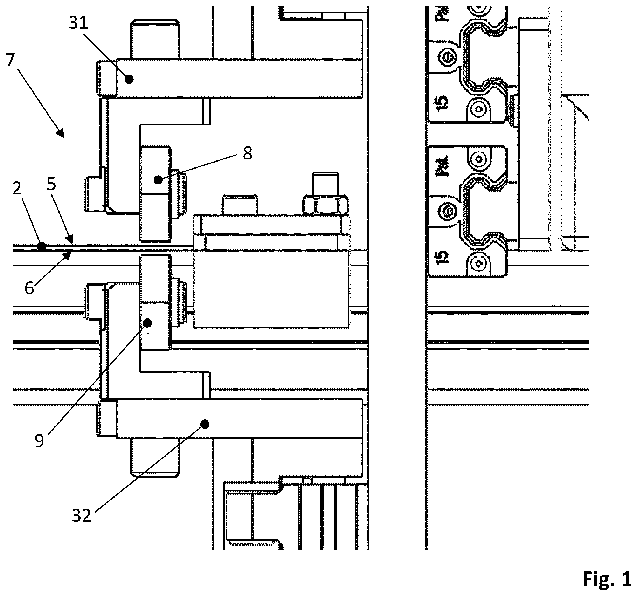

Mit der Figur 1 wird die Ablösevorrichtung 7 zum Ablösen der Schutzfolien 5 und 6 gezeigt. Die erste Schutzfolie 5 befindet sich auf der Oberseite des plattenförmigen Gegenstands 2 und die zweite Schutzfolie 6 befindet sich auf der Unterseite des plattenförmigen Gegenstands 2. Der plattenförmige Gegenstand 2 wird von einer Haltevorrichtung 33 geklemmt.

Im Folgenden wird die erfindungsgemäße Vorrichtung zum Ablösen einer Schutzfolie nur anhand einer Trommel 3 gezeigt, welche die obere Schutzfolie 5 ablöst und aufnimmt. Hierauf ist die Erfindung jedoch nicht beschränkt. Selbstverständlich kann auch mindestens ein weiterer, schwenkbarer Kontaktarm 12 und mindestens eine weitere Trommel 3 auf der Unterseite des plattenförmigen Gegenstands 2 angeordnet sein, welche die unterseitige Schutzfolie 6 ablösen und aufnehmen.

Die Ablösevorrichtung 7 ist im Bereich der Trommel 3 angeordnet und besteht aus einem ersten beweglichen Arm 31, an welchem eine Rolle 8 drehbar angeordnet ist und einem gegenüberliegenden, zweiten beweglichen Arm 32, an welchem eine zweite Rolle 9 drehbar angeordnet ist. Um die Schutzfolien 5, 6 von dem plattenförmigen Gegenstand 2 abzulösen, wird der plattenförmige Gegenstand 2 zwischen den beiden Rollen 8, 9 angeordnet. Die beiden Rollen 8, 9 können für die Aufnahme des plattenförmigen Gegenstand 2 durch eine vertikale Bewegung der Arme 31, 32 auseinandergefahren werden.

Der Ablösevorgang der beiden Schutzfolien 5, 6 wird vorzugsweise nur im Randbereich des plattenförmigen Gegenstands 2 durchgeführt. Folglich wird der plattenförmige Gegenstand 2 soweit in die Ablösevorrichtung 7 eingeschoben und mit der Haltevorrichtung 33 geklemmt bis die beiden Rollen 8, 9 auf den Randbereich der Schutzfolien 5, 6 aufgesetzt werden können.

Um die Schutzfolien 5, 6 von dem plattenförmigen Gegenstand 2 zu lösen, werden die Rollen 8, 9 auf den plattenförmigen Gegenstand 2 aufgesetzt und üben eine definierte Druckkraft (Aufstandskraft) in z-Richtung aus, wobei die Bewegungsrichtung in x-Richtung erfolgt.

Die beiden Rollen 8, 9 weisen eine glatte Oberfläche auf. Die Anordnung der beiden Rollen an den Armen 31 und 32 erfolgt in einem rechten Winkel gegenüber der Bewegungsrichtung, so dass bei dieser Ausführungsform ein Längswalzen stattfindet.

Die beiden Rollen 8, 9 können jedoch auch mit einer Schrägstellung angeordnet sein. Dies bedeutet, dass die beiden Rollen 8, 9 in einem Winkel angestellt sind, wobei eine tangentiale Druckkraft und eine Bewegung der Rollen 8, 9 in Längsrichtung, d.h. parallel zur Vorderkante des plattenförmigen Gegenstandes 2, eine Reibung auf die Schutzfolie (5, 6) bewirkt. In diesem Fall erfährt der plattenförmige Gegenstand 2 durch die Reibung mit den Rollen 8, 9 gleichzeitig eine Längs- und eine Drehbewegung, wodurch die Schutzfolien 5, 6 gestresst werden und sich dadurch von dem plattenförmigen Gegenstand 2 im Randbereich ablösen.

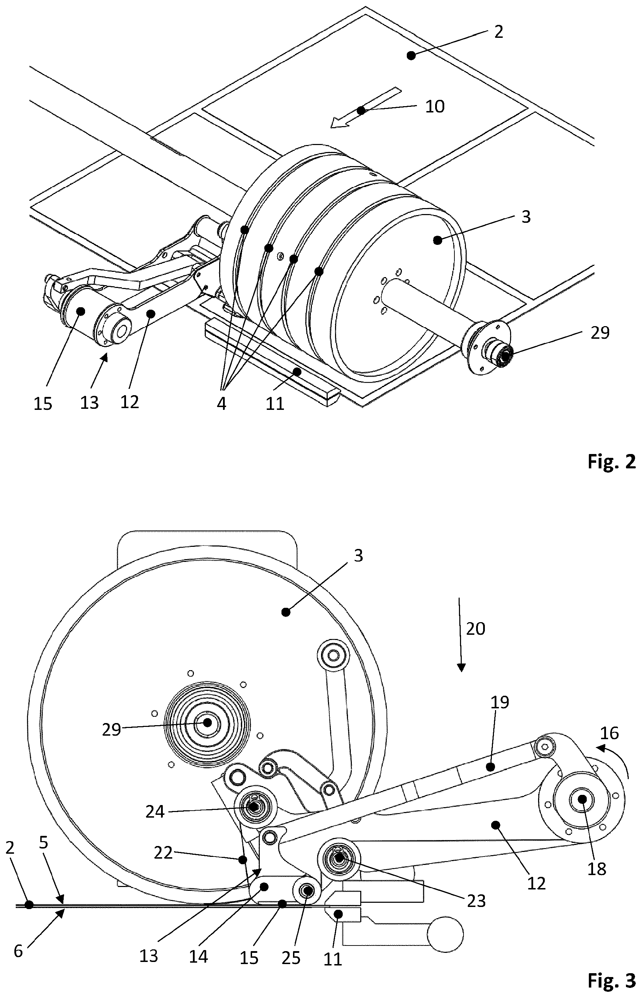

Mit der Figur 2 wird die erfindungsgemäße Vorrichtung 1 zum Ablösen von Schutzfolien 5, 6 von einem plattenförmigen Gegenstand 2 gezeigt. Die Vorschubbewegung des plattenförmigen Gegenstands 2 ist mit der Pfeilrichtung 10 dargestellt. Die Vorrichtung 1 weist eine angetriebene Trommel 3 zum Aufnehmen der Schutzfolien 5, 6 des plattenförmigen Gegenstands 2 auf. Die Trommel 3 weist eine Trommeloberfläche mit Rillen 4 auf, in welche Luft eingeblasen werden. Dadurch entsteht ein Unterdruck und die abgelöste Schutzfolie haftet an der Trommeloberfläche. Im Bereich der Trommel 3 befindet sich ein schwenkbarer Kontaktarm 12 mit einem Kontaktkopf 13. Die Haltevorrichtung 11 befindet nach der Trommel und fixiert den plattenförmiger Gegenstand 2.

Figur 3 zeigt die erfindungsgemäße Vorrichtung 1 in einer Seitenansicht. Der Kontaktarm 12 weist einen eigenen Antrieb auf und ist um eine Achse 18 drehbar gelagert. Gemäß Figur 3 wurde der Kontaktarm 12 mit einer Drehbewegung 16 in Richtung des plattenförmigen Gegenstands 2 geschwenkt. Der Kontaktarm 12 ist mechanisch mit dem Gestänge 19 und dem Stempel 14 gekoppelt. Das Gestänge 19 weist ferner einen eigenen Antrieb auf.

Der Kontaktarm 12 weist an seinem einem vorderen Ende einen Kontaktkopf 13 mit einem Stempel 14 und einer Stempelfläche 15 auf. Der Kontaktkopf mit dem Stempel 14 dient zum Kontaktieren des Klebebands 22 mit der Schutzfolie 5, 6 des plattenförmigen Gegenstands 2 und ist schwenkbar am Kontaktarm 12 angeordnet. Die Schwenkbewegung des Kontaktkopfes 13 mit dem Stempel 14 erfolgt über ein Gestänge 19, welches mit einem Antrieb verbunden ist.

Durch eine Bewegung des Gestänges 19 findet eine Schwenkbewegung des Stempels 14 um eine Umlenkrolle 25 statt. Die Schwenkbewegung bewirkt somit, dass die Stempelfläche 15 entweder vollflächig oder nur partiell auf der Schutzfolie 5, 6 des plattenförmigen Gegenstands 2 aufliegt. Unter einem partiellen Aufliegen wird beispielsweise nur noch eine Kontaktierung des Stempels 14 mit der Schutzfolie 5, 6 im Bereich der Umlenkrolle 25 verstanden.

Im Bereich des Kontaktarmes 12 befindet sich eine Umlenkrolle 23 von dem Klebebandspender, welche neues Klebeband 22 für den Ablösevorgang bereitstellt. Das Klebeband 22 wird ausgehend von dem Klebebandspender über die Umlenkrollen 23, 25 und die Stempelfläche 15 über die Umlenkrolle 24 zum Klebebandsammler geführt, welcher das benutzte Klebeband 22 wieder aufsammelt. Der Klebebandspender und der Klebebandsammler sind als Rollen ausgebildet, welche das Klebeband 22 ab- und wieder aufrollen.

Gemäß der Figur 3 befindet sich der Stempel 14 mit seiner Stempelfläche 15 vollflächig auf der oberen Schutzfolie 5, wobei zwischen der Stempelfläche 15 und der Schutzfolie 5 sich das Klebeband 22 befindet.

Der plattenförmige Gegenstand 2 wird während des gesamten Ablösevorgangs im Randbereich von einer c gehalten. Die Haltevorrichtung 11 weist hierfür beispielsweise zwei gegenüberliegende Niederhalter auf, welche von beiden Seiten den plattenförmigen Gegenstand festklemmen.

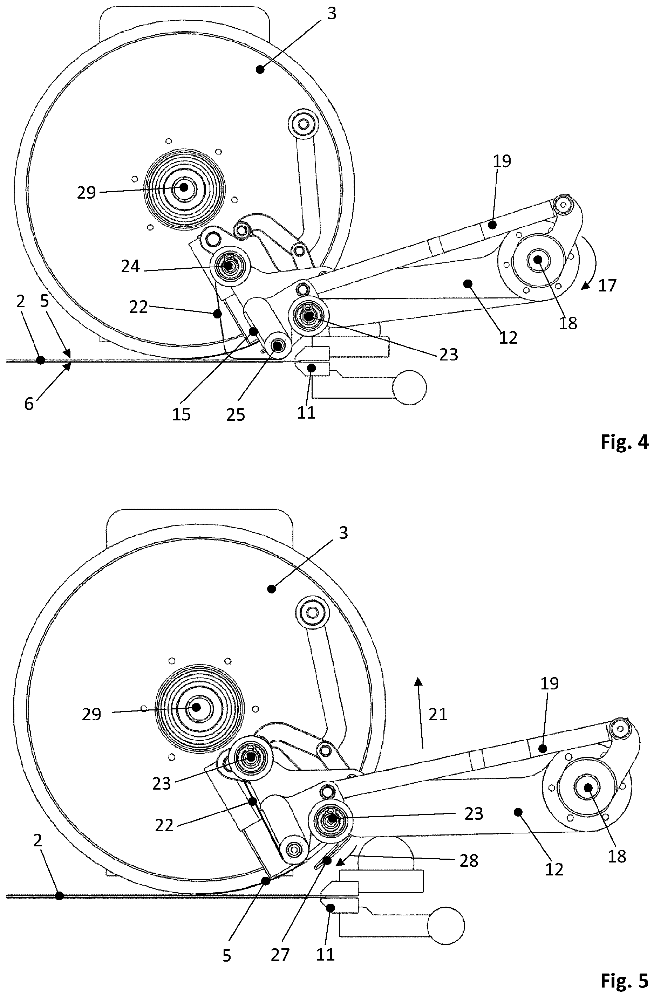

Anhand der Figur 4 ist zu erkennen, dass das Gestänge 19 mit der Drehbewegung 17 bewegt wurde, wodurch sich der Stempel 14 mit seiner Stempelfläche 15 aufgestellt hat, so dass nur noch eine Kontaktierung des Stempels 14 mit dem Klebeband 22 und der Schutzfolie 5 im Bereich der Umlenkrolle 25 vorliegt. Ein Teil des Klebebands 22 hängt "frei" zwischen der Umlenkrolle 25 und dem Klebebandsammler 24.

Figur 5 zeigt ein erstes Ablösen der Schutzfolie 5 von der Oberfläche des plattenförmigen Gegenstands 2. Zunächst wurde die Umlenkrolle 23 gesperrt und der Klebebandsammler 24 gedreht, wodurch das Klebeband 22 mit einer Zugkraft nach oben d.h. weg von der Oberfläche des plattenförmigen Gegenstands 2 bewegt wird und dadurch gleichzeitig die Schutzfolie 5 nach oben gezogen wird. Im Anschluss daran wird der Kontaktarm 12 in Pfeilrichtung 21 nach oben bewegt. Die Schutzfolie 5 klebt an dem Klebeband 22 und wird durch die Bewegung des Kontaktarms 12 nach oben gezogen und löst sich somit weiter von dem plattenförmigen Gegenstand 2 ab.

Nach dem erfolgtem, teilweisen Ablösen und Anheben der Schutzfolie 5 von dem plattenförmigen Gegenstand 2 schwenkt ein Greifer 27 einer Klemmvorrichtung 26 in Pfeilrichtung 28 aus. Mit Hilfe der Klemmvorrichtung 26 wird die abgelöste Schutzfolie 5 gehalten und an die Trommel 3 übergeben.

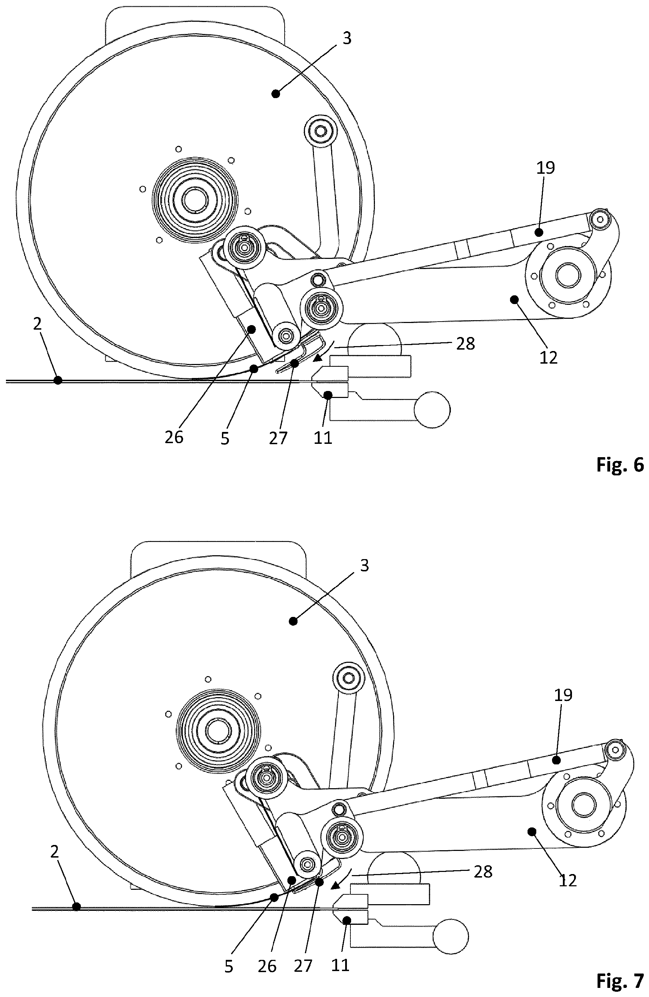

Figur 6 zeigt ein weiteres Ausschwenken des Greifers 27 in Pfeilrichtung 28. Vorzugsweise befinden sich jeweils ein Greifer 27 auf jeder Seite der Trommel 3, wodurch die Schutzfolie 5 jeweils im seitlichen Randbereich gehalten wird.

Figur 7 zeigt ein finales Klemmen der Schutzfolie 5 durch die Klemmvorrichtung 26.

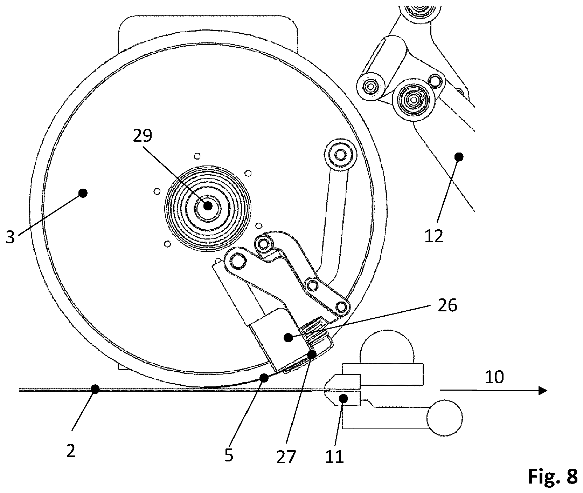

Mit der Figur 8 wird die Übergabe der abgelösten Schutzfolie 5 an die Trommel 3 gezeigt. Die Trommel 3 weist einzelne Rillen 4 auf, mit welchen die Schutzfolie 5 an der Oberfläche gehalten wird. Durch eine Drehbewegung der Trommel 3 wird die Schutzfolie 5 weiter von dem plattenförmigen Gegenstand 2 abgezogen, wobei der plattenförmige Gegenstand 2 in Pfeilrichtung 10 an der Trommel 3 vorbeibewegt wird.

Nach dem die Schutzfolie 5 von dem plattenförmigen Gegenstand abgezogen ist, wird der Kontaktarm 12 entgegen der Drehbewegung 16 wieder weggeschwenkt und gleichzeitig das Klebeband 22 von dem Klebebandsammler synchron zur Schwenkbewegung des Kontaktarms 12 aufgewickelt. Die Haltevorrichtung 11 wird danach geöffnet und gibt den plattenförmigen Gegenstand 2 wieder frei.

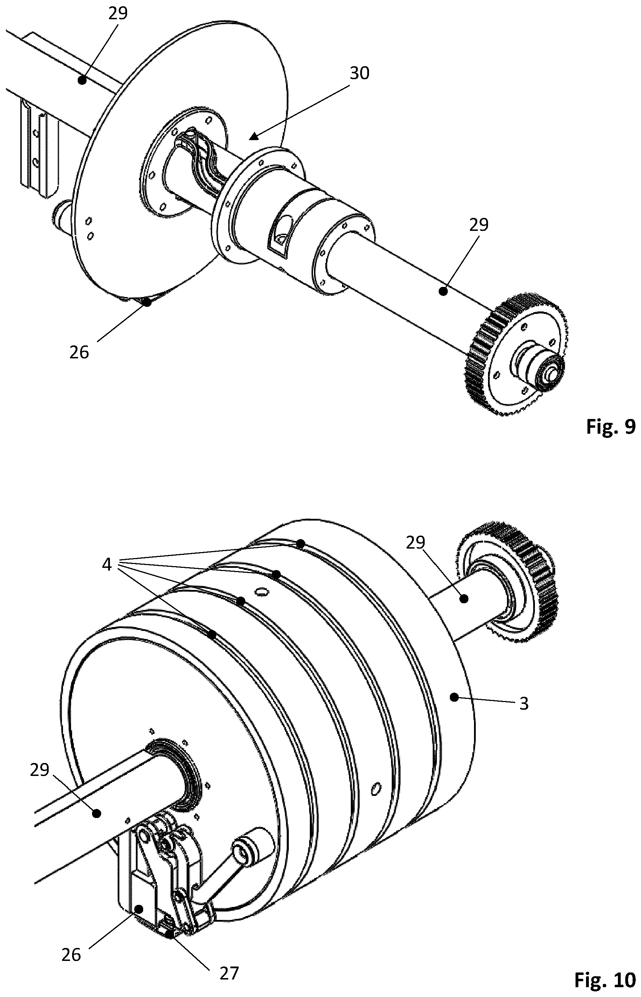

Mit den Figur 9 und 10 wird die Klemmvorrichtung 26 im Detail gezeigt. Die Klemmvorrichtung 26 besteht aus einer angetriebenen Welle 29, welche sich durch die Trommel 3 erstreckt.

Gemäß der Figur 9 weist die Klemmvorrichtung 26 eine Kulissenführung auf, welche die Drehbewegung der Welle in eine vertikale Bewegung eines Kniehebels umwandelt. Der Kniehebel ist mit dem Greifer verbunden und klemmt die Schutzfolie 5, 6.

Anhand der Figur 10 ist zu erkennen, dass sich die Welle 29 durch die Trommel 3 hindurcherstreckt, wobei seitlich neben der Trommel 3 die Klemmvorrichtung 26 angeordnet ist. Es findet somit eine Betätigung des Greifers 26 von außen, d.h. außerhalb der Trommel 3 statt.

### Zeichnungslegende

- 1.: Vorrichtung
- 2.: plattenförmiger Gegenstand
- 3.: Trommel
- 4.: Auslass
- 5.: Schutzfolie
- 6.: Schutzfolie
- 7.: Ablösevorrichtung
- 8.: Rolle
- 9.: Rolle
- 10.: Pfeilrichtung
- 11.: Haltevorrichtung
- 12.: Kontaktarm
- 13.: Kontaktkopf
- 14.: Stempel
- 15.: Stempelfläche
- 16.: Drehbewegung
- 17.: Drehbewegung
- 18.: Achse (von 12)
- 19.: Gestänge
- 20.: Pfeilrichtung (Absenken)
- 21.: Pfeilrichtung (Anheben)
- 22.: Klebeband
- 23.: Umlenkrolle von Klebebandspender
- 24.: Umlenkrolle von Klebebandsammler
- 25.: Umlenkrolle
- 26.: Klemmvorrichtung
- 27.: Greifer
- 28.: Pfeilrichtung von 27
- 29.: Welle
- 30.: Kulissenführung
- 31.: Arm (oben)
- 32.: Arm (unten)
- 33.: Haltevorrichtung

## Patentansprüche

1. Vorrichtung (1) zum Abziehen mindestens einer Schutzfolie (5, 6) von einem plattenförmigen Gegenstand (2), wobei eine Ablösevorrichtung (7) mit mindestens einer Rolle (8, 9) eine Druckkraft auf die Schutzfolie (5, 6) im Randbereich des plattenförmigen Gegenstands (2) ausübt und dadurch die Schutzfolie (5, 6) löst, wobei mit mindestens einem Klebeband (22) die Schutzfolie (5, 6) von dem plattenförmigen Gegenstand (2) zumindest teilweise angehoben und von mindestens einer drehend angetriebenen Trommel (3) mitgenommen wird, **dadurch gekennzeichnet, dass** zur Applizierung des Klebebands (22) die Vorrichtung (1) mindestens einen schwenkbaren Kontaktarm (12) und einem daran angeordneten Stempel (14) mit einer Stempelfläche (15) zur flächigen Kontaktierung des Klebebands (22) mit der Schutzfolie (5, 6) aufweist und dass der Kontaktarm (12) mit Hilfe eines Antriebs auf den plattenförmigen Gegenstand (2) aufsetzbar und von dem plattenförmigen Gegenstand (2) wieder abhebbar ist, wobei durch ein Anheben des Kontaktarms (12) sich die Schutzfolie (5, 6) von dem plattenförmigen Gegenstand (2) ablöst.

2. Vorrichtung nach Anspruch 1, **dadurch gekennzeichnet, dass** das Klebeband (22) über die Stempelfläche (15) führbar ist und die Stempelfläche (15) vollflächig mit dem Klebeband bedeckbar ist.

3. Vorrichtung nach Anspruch 1 oder 2, **dadurch gekennzeichnet, dass** das Klebeband (22) ausgehend von einem Klebebandspender über die Stempelfläche (15) zu einem Klebebandsammler führbar ist.

4. Vorrichtung nach einem der Ansprüche 1 bis 3, **dadurch gekennzeichnet, dass** der Kontaktarm (12) einen Kontaktkopf (13) aufweist, an welchem schwenkbar der Stempel (14) mit seiner Stempelfläche (15) angeordnet ist und dass die Stempelfläche (15) parallel zu der Oberfläche des plattenförmigen Gegenstands ausschwenkbar ist.

5. Vorrichtung nach einem der Ansprüche 1 bis 4, **dadurch gekennzeichnet, dass** der schwenkbare Kontaktarm (12) im Bereich der Trommel (3) angeordnet ist.

6. Vorrichtung nach einem der Ansprüche 1 bis 5, **dadurch gekennzeichnet, dass** die Vorrichtung (1) eine Klemmvorrichtung (26) mit mindestens einem Greifer (27) aufweist, welche im Bereich der Trommel (3) angeordnet ist und die abgelöste Schutzfolie (5, 6) greift und an die Trommel (3) übergibt.

7. Vorrichtung nach Anspruch 6, **dadurch gekennzeichnet, dass** die Klemmvorrichtung (26) eine angetriebene Welle (29) mit einer Kulissenführung (30) aufweist, wobei sich die Welle (29) durch die Trommel (3) erstreckt und dass der Greifer (27) als Kniehebel ausgebildet ist und bei einer Drehbewegung der Welle (29) sich schließt oder öffnet.

8. Vorrichtung nach einem der Ansprüche 6 oder 7, **dadurch gekennzeichnet, dass** die Klemmvorrichtung (26) zwei beabstandete Greifer (27) aufweist, welche sich auf beiden Seiten der Trommel (3) befinden und die abgelöste Schutzfolie (5, 6) greifen, halten und an die Trommel (3) abgeben.

9. Vorrichtung nach einem der Ansprüche 1 bis 8, **dadurch gekennzeichnet, dass** die Ablösevorrichtung (7) als Rändel- oder Walzvorrichtung ausgebildet ist.

10. Vorrichtung nach einem der Ansprüche 1 bis 9, **dadurch gekennzeichnet, dass** die Ablösevorrichtung (7) mindestens eine Rolle (8, 9) aufweist, welche gegen den Rand des plattenförmigen Gegenstands gepresst und abgewälzt wird.

11. Vorrichtung nach einem der Ansprüche 1 bis 10, **dadurch gekennzeichnet, dass** die Ablösevorrichtung (7) mindestens eine glatte Rolle (8, 9) aufweist, welche zur Walzachse geneigt ist, wobei die Rollen (8, 9) bei einer Bewegung in Längsrichtung eine Reibung auf die Schutzfolie (5, 6) bewirken.

12. Vorrichtung nach einem der Ansprüche 1 bis 11, **dadurch gekennzeichnet, dass** die Ablösevorrichtung (7) mindestens eine schräg angestellte Rolle (8, 9) aufweist, wobei die Anstellung der Rolle in einem Winkel von 5-30° zur Verfahrensachse erfolgt.

13. Verfahren zum Abziehen mindestens einer Schutzfolie (5, 6) von einem plattenförmigen Gegenstand (2), wobei die abgelöste Schutzfolie (5, 6) von mindestens einer Trommel (3) aufgenommen wird, **gekennzeichnet durch** folgende Schritte:
• Absenken eines Kontaktarms (12) mit einem daran schwenkbar angeordneten Stempel (14) mit einer Stempelfläche (15) in Richtung des plattenförmigen Gegenstands (2);
• Ausschwenken des Stempels (14) bis die Stempelfläche (15) parallel zur Oberfläche des plattenförmigen Gegenstands (2) ist, wobei beim Ausschwenken des Stempels (14) sich ein Klebeband (22) an die Stempelfläche (15) anlegt;
• Aufsetzen des Stempels (14) auf die Schutzfolie (5, 6) des plattenförmigen Gegenstands (2) und damit flächiges Kontaktieren des Klebebands (22) mit der Schutzfolie (5, 6);
• Einschwenken des Stempels (14);
• Anheben des Kontaktarms (12) mit einem definierten Abstand gegenüber dem plattenförmigen Gegenstand (2), wobei die Schutzfolie (5, 6) an dem Klebeband (22) haftet und von dem plattenförmigen Gegenstand (2) angehoben wird;
• Greifen der abgelösten Schutzfolie (5, 6) mit mindestens einem Greifer (27) einer Klemmvorrichtung (26);
• Übergabe der gelösten Schutzfolie (5, 6) ausgehend von der Klemmvorrichtung (26) auf die Trommel (3), welche die Schutzfolie (5, 6) von dem plattenförmigen Gegenstand (2) abzieht.

14. Verfahren nach Anspruch 13, **dadurch gekennzeichnet, dass** die Schutzfolie (5, 6) von einer Ablösevorrichtung (7) im Randbereich des plattenförmigen Gegenstands (2) abgelöst wird, wobei die Ablösevorrichtung (7) mindestens eine glatte Rolle (8, 9) aufweist, welche in einem Winkel angestellt ist, wobei eine tangentiale Druckkraft und eine Bewegung der Rollen (8, 9) in Längsrichtung, d.h. parallel zur Vorderkante des plattenförmigen Gegenstandes (2), eine Reibung auf die Schutzfolie (5, 6) bewirkt.

## Claims

1. A device (1) for peeling at least one protective film (5, 6) from a plate-shaped object (2), wherein a detaching device (7) comprising at least one roller (8, 9) exerts a compressive force on the protective film (5, 6) in the edge region of the plate-shaped object (2) and thereby detaches the protective film (5, 6), wherein the protective film (5, 6) is at least partially lifted off from the plate-shaped object (2) by at least one adhesive tape (22) and is carried away by at least one rotatably driven drum (3), **characterised in that**, for the application of the adhesive tape (22), the device (1) comprises at least one pivotable contact arm (12) and a stamp (14) disposed thereon with a stamping surface (15) for making full-surface contact between the adhesive tape (22) and the protective film (5, 6), and **in that** the contact arm (12) can be placed onto the plate-shaped object (2) and lifted off from the plate-shaped object (2) again by means of a drive, wherein lifting the contact arm (12) causes the protective film (5, 6) to be detached from the plate-shaped object (2).

2. The device according to claim 1, **characterised in that** the adhesive tape (22) can be guided over the stamping surface (15) and the stamping surface (15) can be covered over its entire surface with the adhesive tape.

3. The device according to claim 1 or 2, **characterised in that** the adhesive tape (22) can be guided from an adhesive tape dispenser over the stamping surface (15) to an adhesive tape collector.

4. The device according to any one of claims 1 to 3, **characterised in that** the contact arm (12) comprises a contact head (13) on which the stamp (14) is pivotally disposed with its stamping surface (15), and **in that** the stamping surface (15) can be pivoted out so as to be parallel to the surface of the plate-shaped object.

5. The device according to any one of claims 1 to 4, **characterised in that** the pivotable contact arm (12) is disposed in the region of the drum (3).

6. The device according to any one of claims 1 to 5, **characterised in that** the device (1) comprises a clamping device (26) with at least one gripper (27), which is disposed in the region of the drum (3) and grips the detached protective film (5, 6) and transfers it to the drum (3).

7. The device according to claim 6, **characterised in that** the clamping device (26) comprises a driven shaft (29) with a slide guide (30), wherein the shaft (29) extends through the drum (3), and **in that** the gripper (27) is designed as a toggle lever and closes or opens as the shaft (29) rotates.

8. The device according to any one of claims 6 or 7, **characterised in that** the clamping device (26) comprises two spaced-apart grippers (27), which are located on either side of the drum (3) and which grip, hold and transfer the detached protective film (5, 6) to the drum (3).

9. The device according to any one of claims 1 to 8, **characterised in that** the detaching device (7) is designed as a knurling or rolling device.

10. The device according to any one of claims 1 to 9, **characterised in that** the detaching device (7) comprises at least one roller (8, 9) which is pressed against the edge of the plate-shaped object and rolled off.

11. The device according to any one of claims 1 to 10, **characterised in that** the detaching device (7) comprises at least one smooth roller (8, 9) that is inclined relative to the rolling axis, wherein the rollers (8, 9) exert friction on the protective film (5, 6) during movement in the longitudinal direction.

12. The device according to any one of claims 1 to 11, **characterised in that** the detaching device (7) comprises at least one inclined roller (8, 9), wherein the roller is inclined at an angle of 5-30° to the direction of travel.

13. A method for peeling off at least one protective film (5, 6) from a plate-shaped object (2), wherein the detached protective film (5, 6) is taken up by at least one drum (3), **characterised by** the following steps:
• lowering a contact arm (12), to which a stamp (14) with a stamping surface (15) is pivotally disposed, towards the plate-shaped object (2);
• swivelling the stamp (14) outwards until the stamp surface (15) is parallel to the surface of the plate-shaped object (2), wherein, as the stamp (14) is swivelled outwards, an adhesive tape (22) adheres to the stamp surface (15);
• placing the stamp (14) onto the protective film (5, 6) of the plate-shaped object (2) and thereby bringing the adhesive tape (22) into full-surface contact with the protective film (5, 6);
• swivelling the stamp (14) back into position;
• lifting the contact arm (12) to a defined distance from the plate-shaped object (2), wherein the protective film (5, 6) adheres to the adhesive tape (22) and is lifted off from the plate-shaped object (2);
• gripping the detached protective film (5, 6) with at least one gripper (27) of a clamping device (26);
• transferring the detached protective film (5, 6) from the clamping device (26) to the drum (3), which pulls the protective film (5, 6) away from the plate-shaped object (2).

14. The method according to claim 13, **characterised in that** the protective film (5, 6) is detached by a detaching device (7) in the edge region of the plate-shaped object (2), wherein the detaching device (7) comprises at least one smooth roller (8, 9) which is set at an angle, so that a tangential compressive force and a movement of the rollers (8, 9) in the longitudinal direction, i.e. parallel to the leading edge of the plate-shaped object (2), cause friction on the protective film (5, 6).

## Revendications

1. Dispositif (1) pour retirer au moins un film de protection (5, 6) d'un objet en forme de plaque (2), dans lequel un dispositif de détachement (7) comprenant au moins un rouleau (8, 9) exerce une force de pression sur le film de protection (5, 6) dans la zone de bord de l'objet en forme de plaque (2) et détache ainsi le film de protection (5, 6), dans lequel le film de protection (5, 6) est soulevé au moins partiellement de l'objet en forme de plaque (2) avec au moins un ruban adhésif (22) et emporté par au moins un tambour (3) entraîné en rotation, **caractérisé en ce que** pour l'application du ruban adhésif (22), le dispositif (1) présente au moins un bras de contact (12) pivotant et un tampon (14) disposé dessus comprenant une surface de tampon (15) pour le contact plan du ruban adhésif (22) avec le film de protection (5, 6), et qu'à l'aide d'un entraînement, le bras de contact (12) peut être posé sur l'objet en forme de plaque (2) et peut à nouveau être soulevé de l'objet en forme de plaque (2), dans lequel, en soulevant le bras de contact (12), le film de protection (5, 6) se détache de l'objet en forme de plaque (2).

2. Dispositif selon la revendication 1, **caractérisé en ce que** le ruban adhésif (22) peut être guidé sur la surface de tampon (15), et la surface de tampon (15) peut être recouverte sur toute sa surface par le ruban adhésif.

3. Dispositif selon la revendication 1 ou 2, **caractérisé en ce que** le ruban adhésif (22) peut être guidé à partir d'un distributeur de ruban adhésif vers un collecteur de ruban adhésif par l'intermédiaire de la surface de tampon (15).

4. Dispositif selon l'une des revendications 1 à 3, **caractérisé en ce que** le bras de contact (12) présente une tête de contact (13) sur laquelle le tampon (14) est disposé de manière pivotante avec sa surface de tampon (15), et que la surface de tampon (15) peut pivoter vers l'extérieur, parallèlement à la surface de l'objet en forme de plaque.

5. Dispositif selon l'une des revendications 1 à 4, **caractérisé en ce que** le bras de contact (12) pivotant est disposé dans la zone du tambour (3).

6. Dispositif selon l'une des revendications 1 à 5, **caractérisé en ce que** le dispositif (1) présente un dispositif de serrage (26) comprenant au moins une pince (27), qui est disposé dans la zone du tambour (3) et saisit le film de protection (5, 6) détaché et le transfère au tambour (3).

7. Dispositif selon la revendication 6, **caractérisé en ce que** le dispositif de serrage (26) présente un arbre (29) entraîné comprenant un guidage à coulisse (30), dans lequel l'arbre (29) s'étend à travers le tambour (3), et que la pince (27) est conformée en un levier coudé et se ferme ou s'ouvre lors d'un mouvement de rotation de l'arbre (29).

8. Dispositif selon l'une des revendications 6 ou 7, **caractérisé en ce que** le dispositif de serrage (26) présente deux pinces (27) espacées qui se trouvent de part et d'autre du tambour (3) et saisissent le film de protection (5, 6) détaché, le maintiennent et le déposent sur le tambour (3).

9. Dispositif selon l'une des revendications 1 à 8, **caractérisé en ce que** le dispositif de détachement (7) est conformé en dispositif de moletage ou de laminage.

10. Dispositif selon l'une des revendications 1 à 9, **caractérisé en ce que** le dispositif de détachement (7) présente au moins un rouleau (8, 9) qui est pressé et roulé contre le bord de l'objet en forme de plaque.

11. Dispositif selon l'une des revendications 1 à 10, **caractérisé en ce que** le dispositif de détachement (7) présente au moins un galet (8, 9) lisse, qui est incliné par rapport à l'axe de laminage, dans lequel les galets (8, 9) provoquent un frottement sur le film de protection (5, 6) lors d'un mouvement dans la direction longitudinale.

12. Dispositif selon l'une des revendications 1 à 11, **caractérisé en ce que** le dispositif de détachement (7) présente au moins un galet (8, 9) positionné en biais, dans lequel le positionnement du galet s'effectue à un angle de 5-30° par rapport à l'axe de procédé.

13. Procédé pour retirer au moins un film de protection (5, 6) d'un objet en forme de plaque (2), dans lequel le film de protection (5, 6) détaché est reçu par au moins un tambour (3), **caractérisé par** les étapes suivantes :
• abaisser un bras de contact (12) comprenant un tampon (14), avec une surface de tampon (15), disposé de manière pivotante sur celui-ci en direction de l'objet en forme de plaque (2) ;
• pivoter le tampon (14) vers l'extérieur jusqu'à ce que la surface de tampon (15) soit parallèle à la surface de l'objet en forme de plaque (2), dans lequel lors du pivotement vers l'extérieur du tampon (14), un ruban adhésif (22) s'applique sur la surface de tampon (15) ;
• mettre en place le tampon (14) sur le film de protection (5, 6) de l'objet en forme de plaque (2) et ainsi le contact plan du ruban adhésif (22) avec le film de protection (5, 6) ;
• pivoter le tampon (14) vers l'intérieur ;
• soulever le bras de contact (12) à une distance définie par rapport à l'objet en forme de plaque (2), dans lequel le film de protection (5, 6) adhère au ruban adhésif (22) et est soulevé de l'objet en forme de plaque (2) ;
• saisir le film de protection (5, 6) détaché avec au moins une pince (27) d'un dispositif de serrage (26) ;
• transférer le film de protection (5, 6) détaché à partir du dispositif de serrage (26) sur le tambour (3), qui retire le film de protection (5, 6) de l'objet en forme de plaque (2).

14. Procédé selon la revendication 13, **caractérisé en ce que** le film de protection (5, 6) est détaché par un dispositif de détachement (7) dans la zone de bord de l'objet en forme de plaque (2), dans lequel le dispositif de détachement (7) présente au moins un galet (8, 9) lisse qui est positionné de manière inclinée, dans lequel une force de pression tangentielle et un mouvement des galets (8, 9) dans la direction longitudinale, c'est-à-dire parallèlement au bord avant de l'objet en forme de plaque (2), provoquent un frottement sur le film de protection (5, 6).
